(19) Europäisches Patentamt
European Patent Office
Office européen des brevets

(11) EP 0 977 050 B1

(12) **EUROPEAN PATENT SPECIFICATION**

(45) Date of publication and mention
of the grant of the patent:
**02.10.2002 Bulletin 2002/40**

(51) Int Cl.⁷: $G01S\ 7/20$, G01S 13/89, G01R 23/163

(21) Application number: **99203844.8**

(22) Date of filing: **12.01.1995**

(54) **Display apparatus**

Anzeigevorrichtung

Appareil d'affichage

(84) Designated Contracting States:
**DE FR GB NL SE**

(30) Priority: **12.01.1994 JP 157494**
**12.01.1994 JP 157594**
**13.01.1994 JP 190494**
**19.01.1994 JP 410794**
**21.01.1994 JP 540294**

(43) Date of publication of application:
**02.02.2000 Bulletin 2000/05**

(62) Document number(s) of the earlier application(s) in
accordance with Art. 76 EPC:
**95400057.6 / 0 667 538**

(73) Proprietor: **ADVANTEST CORPORATION**
**Nerima-Ku Tokyo (JP)**

(72) Inventor: **Kitayoshi, Hitoshi**
**Tokyo (JP)**

(74) Representative: **Joly, Jean-Jacques et al**
**Cabinet Beau de Loménie**
**158, rue de l'Université**
**75340 Paris Cédex 07 (FR)**

(56) References cited:
**EP-A- 0 140 539        EP-A- 0 324 880**
**FR-A- 2 096 730**

• **PATENT ABSTRACTS OF JAPAN vol. 7, no. 138 (P-204), 16 June 1983 (1983-06-16) & JP 58 053778 A (TOKYO KEIKI KK), 30 March 1983 (1983-03-30)**

**Description**

FIELD OF THE INVENTION

The invention relates to display apparatus, notably to display apparatus for displaying space propagation states of waves, such as electromagnetic waves and sound waves, including such waves detected by non-contact type wave signal observation apparatus.

More particularly, the invention relates to a display apparatus which displays space propagation states of waves, such as electromagnetic waves and sound waves, and/or displays the results of holographic radars using waves such as electromagnetic waves and sound waves.

BACKGROUND OF THE INVENTION

First there shall be described the prior art relating to the present invention.

Three-dimensional shapes in real number space can be expressed using two-dimensional computer graphics, for example by methods in which distance is expressed by varying brightness, i.e. by shading. However, up until now, three-dimensional shapes in complex number space - such as representations of electromagnetic waves, which have not only intensity information but also phase information, polarity information, axial ratio information, etc. - have not been able to be expressed on two-dimensional surfaces.

SUMMARY OF THE INVENTION

The present invention provides a display apparatus for complex wave interference information. Complex two-dimensional wave interference data is observed and hologram reconstruction calculations are applied to the signals representing the observed data. The results of the hologram reconstruction calculations are converted from an orthogonal system to a polar co-ordinate system. Phase information of the converted data is converted to hue information and displayed modulated by amplitude information of the converted data, so as to produce a two-dimensional colour image.

BRIEF DESCRIPTION OF THE DRAWINGS

Fig. 1 is a block diagram showing an embodiment of a complex wave interference information display apparatus according to the present invention.

Fig.2 shows an example of results displayed using the apparatus of Fig.1.

Fig.3 is a block diagram showing two-dimensional interference data observation means (here, a holographic radar) useable to furnish data for display by the display apparatus according to the present invention.

Fig.4 is a block diagram showing further complex wave interference information observation means useable to furnish data for display by the display apparatus according to the present invention.

Fig.5 is a block diagram showing still further two-dimensional interference data observation means useable to furnish data for display by the display apparatus according to the present invention.

DESCRIPTION OF THE PREFERRED EMBODIMENTS

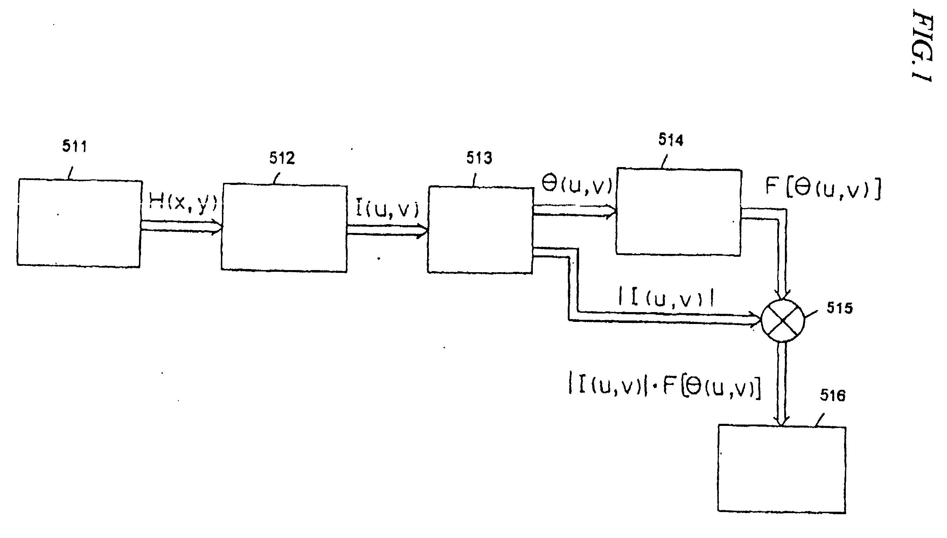

The present invention will now be explained with reference to Figs.1 to 5.

Fig. 1 shows a first preferred embodiment of display apparatus for complex wave information, according to the present invention. Two-dimensional interference data $H(x,y)$ regarding electromagnetic waves in three-dimensional space is obtained from interference data observation means 511. In this example, positions $(x,y)$ in the observation plane are designated using an orthogonal co-ordinate system. Examples of possible constructions of the interference data observation means 511 are given later on. A hologram reconstruction unit 512 performs hologram reconstruction calculations using the two-dimensional interference data $H(x,y)$. The Fraunhofer transform is used in the hologram reconstruction calculations, according to the following equation:

$$I(u,v) = \int \int H(x,y) \exp\{-2j\pi (ux+vy)\} \, dx \, dy \tag{1},$$

where u and v are the azimuth angle and the elevation angle, respectively, when viewed from point $(x,y)$ on the observation plane. For instance, at observation points (x,y) on the observation plane spaced apart from the electromagnetic wave source by a distance Z, two-dimensional interference data H(x,y) are observed which represent the data from the source subjected to the transfer function of $\exp\{(j\pi/\lambda Z)(x^2+y^2)\}$. If hologram reconstruction calculations are performed on this two-dimensional interference data H(x,y) the above propagation function becomes $j\lambda Z \exp\{-j\pi\lambda Z (u^2+v^2)\}$. In addition, the Fourier integral of the observation plane is convolved into this.

A co-ordinate converter 513 converts the result of such hologram reconstruction calculations from orthogonal co-ordinates to polar co-ordinates I(u,v). That is, the real part and the imaginary part of I(u,v) is calculated. The amplitude and the phase of I(u,v) which correspond to these real part and imaginary parts are also calculated. A hue converter 514 converts the phase information θ(u,v) of the co-ordinate-converted data into a colour signal F[θ(u,v)] of a corresponding hue. A multiplication unit 515 modulates the colour signal F[θ(u,v)] by multiplying it by the amplitude information |I(u,v)| of the coordinate-converted data from co-ordinate converter 513. The modulated output |I(u,v)|•F[θ(u,v)] is displayed on a colour display unit 516 as a colour image in the plane of u and v.

For an electromagnetic wave source which is close to the observation plane, the observed amplitude information |I(u,v)| of I(u,v) is large and drops off rapidly towards the periphery of the image corresponding to the source and the observed phase information θ(u,v) changes comparatively slowly while going from the center to the surrounding of the image corresponding to the source. On the other hand, for an electromagnetic wave source which is further away from the observation plane, the observed amplitude information of I(u,v) is small and weakens comparatively slowly while going from the center to the periphery of the image corresponding to the source and the observed phase information changes comparatively rapidly while going from the center to the surrounding of the image corresponding to the source.

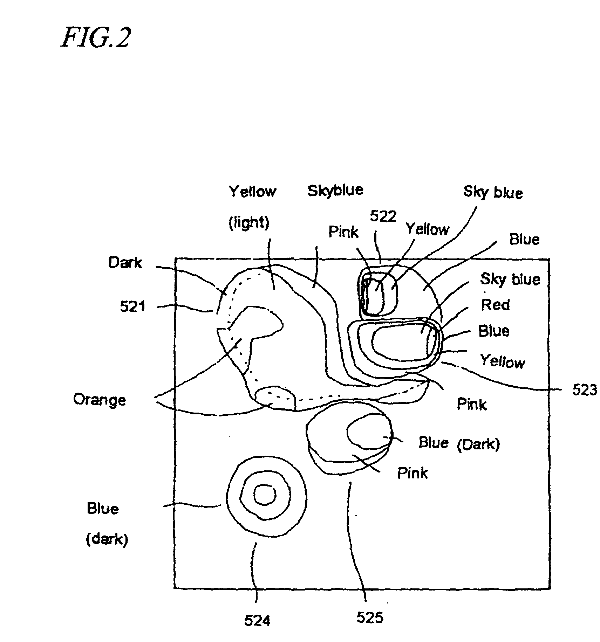

Fig.2 is an example of an image displayed on the display unit 516 when waste/leakage radiation from a piece of electronic equipment is observed at the observation plane by the apparatus of the invention, complex two-dimensional electromagnetic wave interference data is obtained and processing is performed as in the case of Fig.1. The large image 521 on the left upper part of the display is bright, with the brightness reducing rapidly towards the periphery of the image, and the stripes of colour in the image are wide meaning that the observed phase information changes comparatively slowly while going from the center to the surrounding of the image. Therefore, it is understood that image 521 is near the observation plane. Moreover, the colour stripes look wider on the left-hand side than on the right-hand side of image 521 and so an electromagnetic wave of this waste radiation is judged to radiate from the left as seen in the figures.

Image 522, to the right and slightly above image 521 on the image display, is smaller than image 521, has weak brightness and the colour striping is detailed. That is, the phase changes rapidly from the center of the image towards the edges and the striping at the right of the image is coarser than that at the left. That is, it is deduced that image 522 corresponds to a radiation source which is further away and to the right of that corresponding to image 521.

Image 523, between the lower right-hand portion of image 521 and image 522, is slightly larger and brighter than image 522 and the thickness of the colour stripe is about the same as for image 522. Therefore, the radiation source of image 521 is judged to be located at about the same distance as image 522 from the observation plane. However, image 523 corresponds to a slightly stronger source and, from the colour striping, it is understood that this source is radiating to the left because the colour stripes on the right-hand side are finer than those on the left-hand side.

Image 524 spaced apart from image 521 has light and dark portions, the maxilla of the colour stripes are only just fatter than that of the image 522. Therefore, it is judged to correspond to a weak radiation source at a distance which is the same or more than that of the images 522, 523 from the observation plane in the direction perpendicular to the observation plane.

Similarly, image 525, between image 521 and image 524, is judged to correspond to a weak radiation source, radiating to the left, which is comparatively near the observation plane.

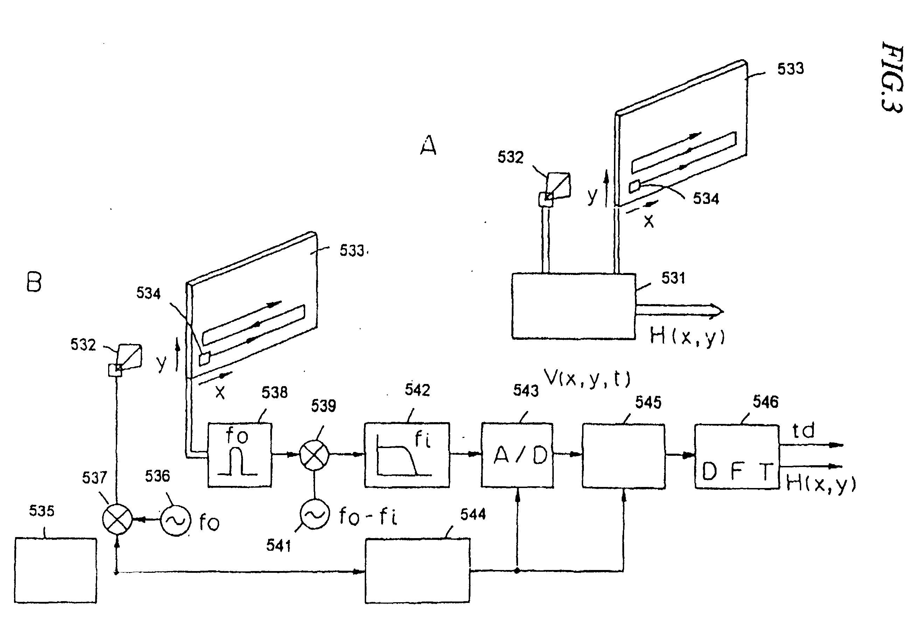

Next, a concrete example of the two-dimensional interference data observation means 511, as shown in Fig. 3, will be described.

In the case of the holographic radar of Fig.3A, a high frequency signal, such as a signal in the microwave or millimeter region, is supplied by network analyzer 531 to antenna 532 for illuminating the observation space with continuously radiated high frequency electromagnetic waves. The reflected waves (which usually are interference waves caused by interference between reflected waves from two or more places in the observation space) are received by receive antenna 534 at each point (x,y) on a hologram observation plane 533 arranged to face the observation space, and the corresponding output is fed to network analyzer 531. An example of the transfer function of the signal path of an electromagnetic wave from the illuminating antenna 532 to a receive point (x,y), that is, two-dimensional interference data H(x,y,f) is given in "Near-Field Antenna Measurement" by Dan Slater (Artech House 1991).

Receive antenna 534 may be moved to each observation point (x,y) on the observation plane 533 so as sequentially to receive the reflected waves falling on the respective points (x,y). Alternatively, a receiving antenna 534 may be provided at each observation point on the observation plane 533 and switched in turn so as to successively feed to network analyzer 531 signals received at each observation point (x,y). That is, reflected waves falling on each observation point (x,y) on the observation plane 533 are received by scanning-antenna receiving means. The frequency F of the illuminating high frequency electromagnetic waves is changed in small steps and the space transfer function, that is, the two-dimensional interference data $H(x,y,f)$ corresponding to the wave path from antenna 532 to observation point (x,y) of the hologram observation plane, is measured at each frequency.

Another example is shown in Fig.3B in which the same reference numerals have been used for parts which correspond to those shown in Fig.3A. A signal of microwave frequency $f_0$ generated by an oscillator 536 is modulated by modulator 537 by a pulse signal from a pulse generator 535 and a resulting high frequency pulse is radiated from antenna 532. The corresponding signal received by antenna 534 is fed to a pass band filter 538 having center frequency $f_0$. The filter output is mixed by a mixer 539 with a local signal of frequency $(f_0-f_i)$ from a local oscillator 541. The mixer output is passed through a low-pass filter 542. Thus the signal of frequency $f_0$ from pass band filter 538 is converted to a signal of low frequency $f_i$. As an example, $f_0$ may be in the range 1GHz - 10 GHz and $f_i$ may be 1 MHz. The low frequency signal is sampled by an analog-to-digital converter 543 in synchronism with a pulse train of a frequency twice that of the low frequency signal and each sample is converted into a digital value. The sampling pulse train is generated by a pulse train generator 544 which receives as an input pulses from pulse generator 535.

The low-frequency-converted receive signal for each receive point (x,y) on the observation plane is thus sampled by the above-mentioned pulse train and the digital sample values $V(x,y,t)$ are stored in a memory 545. A discrete Fourier transform unit 546 performs a discrete Fourier transform on a block of data $V(x,y,t)$ corresponding to a fixed time period $t_d$ read out from memory 545 for a respective receive point (x,y), according to the following equation:

$$H(x,y) = \int V(x,y,t) \exp(-j2\pi f_i) \, dt \qquad (2)$$

The range of the integration here is taken to be $t_d$ to $t_d+\Delta t$.

The thus-obtained results of the Fourier transform are two-dimensional interference data $H(x,y)$ and $t_d$ corresponds to the distance Z from the observation plane 533.

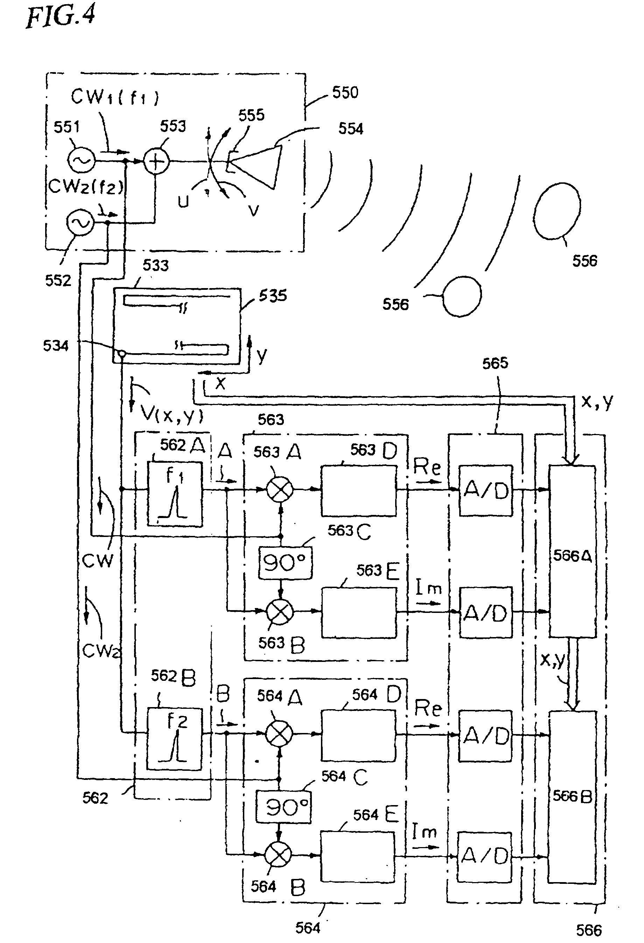

Another example of two-dimensional interference data observation apparatus useable with the image display apparatus of the invention is shown in Fig.4. Continuous wave signals $CW_1, CW_2$ of two frequencies $f_1$, $f_2$ which are close together, produced by sources 551, 552, are combined by an adder 553 and fed to a radiation transducer 554 which radiates in a single direction defined by azimuth and elevation angles u, v. A driving means 555 displaces the radiation transducer 554 so as to vary the azimuth and elevation angles of the radiated beam in an oscillating manner. Elements 551 to 555 are considered to make up an oscillating signal oscillator 550. The frequencies of the signals output by the sources 551, 552 may be $f_1 = 15.003$ GHZ and $f_2 = 15.009$ GHz.

A receiving transducer 534 may be composed of an antenna for receiving electromagnetic waves reflecting from an observation object 556 and may be displaced in directions x,y on an observation plane 535 (hereafter termed "hologram observation plane") facing the observation object 556, so as to scan the observation plane. Whenever radiating transducer 554 performs one sweep of the radiated beam, receiving antenna 534 executes one scan of the hologram observation plane. The hologram data is generated evenly from the whole area of observation object 556 repeatedly from about two to four times.

A frequency selection means 562 separates the hologram received signal $V(x,y)$ received by transducer 534 into a signal A of frequency $f_1$ and a signal B of frequency $f_2$. In this example, frequency selection means 562 is shown as consisting of band pass filters 562A and 562B. Signals A and B separated by frequency selection means 562 are input into respective first Fourier integral means 563, 564. Each of the first Fourier integral means 563, 564 may be composed of a pair of mixers 563A, 563B (564A, 564B), a pair of low pass filters 563D 563E (564D, 564E) and a phaser 563C (564C) which is used to shift the phase of the respective reference signals $CW_1$ $(CW_2)$ by 90° and input the phase-shifted signal to the mixers 563B (564B). The mixers 563A, 563B, 564A, 564B output sum and difference frequencies. In this example, the respective difference frequencies are selected by the low-pass filters 563D, 563E, 564D and 564E. That is, a beat signal is extracted by each of the low pass filters 563D, 563E, 564D and 564E. The real part Re, of the quadrature component of hologram data at each observation point (x,y) is obtained by the mixers 563A, 564A which multiply their respective inputs by the respective reference signals $CW_1$, $CW_2$. Furthermore, the imaginary part, Im, of the quadrature component of hologram observation data at each observation point (x,y) is obtained by mixers 563B, 564B.

The real and imaginary component signals, Re and Im, are fed to analog-to-digital conversion unit 565 and the converted output is supplied to a second Fourier integral means 566. It is possible to provide each of the memories 566A and 566B of the second Fourier integral means 566 as a pair of memories. In such a case, since respective real Re and imaginary Im component signals form pairs it is preferable to store corresponding Re and Im signals at the same addresses in the respective memories making up memories 566A or 566B.

A position signal (x,y) representing the scanning position of the receiving transducer 534 can be fed to the second Fourier integral means 566 to serve as an address for storing the corresponding orthogonal component signals Re, Im. The orthogonal components (real number part Re and imaginary number part Im) concerning each observation point (x,y) stored in the second Fourier integral means 566 can be accessed to obtain two-dimensional interference data $H(x,y,f_1)$ and $H(x,y,f_2)$. Hologram reconstruction calculations are performed on the two-dimensional interference data $H(x,y,f_1)$, $H(x,y,f_2)$ by hologram reconstruction calculation unit 512 of the image display apparatus shown in Fig. 1, according to the following equations:

$$I(u,v,f_1) = \int \int H(x,y,f_1) \exp\{-2j\pi \ (ux+vy)\} \ dx \ dy$$

$$I(u,v,f_2) = \int \int H(x,y,f_2) \exp\{-2j\pi \ (ux+vy)\} \ dx \ dy \qquad (3).$$

The sum $|I(u,v)|$ of amplitude information of the results of these reproduction calculations and the difference $\theta(u,v)$ of phase information are calculated by co-ordinate converter 513 according to the following equations:

$$|I(u,v)| = |I(u,v,f_1)| + |I(u,v,f_2)|$$

$$\theta(u,v) = \theta(u,v,f_1) - \theta(u,v,f_2) \qquad (4).$$

The latter signal is supplied to the hue converter 514 and the former signal is supplied to multiplication unit 515.

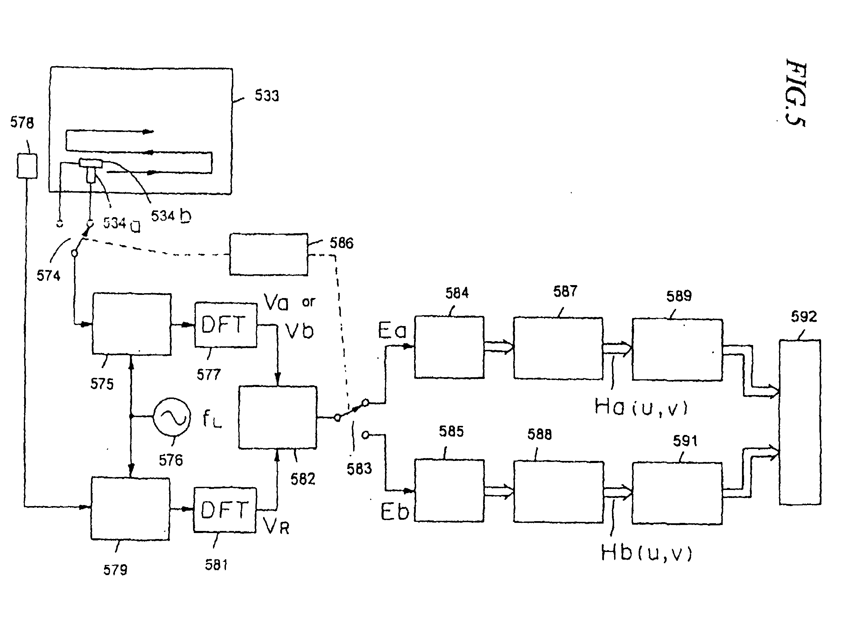

A further example of two-dimensional interference data observation means, here used to observe propagating in space waste/leakage electromagnetic radiation from electronic equipment, suitable for use with the image display unit of Fig.1 will now be described with reference to Fig.5. Antenna-element pair 534a, 534b having mutually orthogonal figure-of-eight beam patterns receive, as in the above-described case, radiation at each observation point (x,y) of the observation plane 533. The received outputs of antennas 534a, 534b are switchably selected by a switch 574 and are supplied to a frequency converter 575, where they are respectively converted to intermediate frequency (IF) signals using a local signal of frequency $f_L$ from local oscillator 576. Each IF signal is subjected a conversion by a discrete Fourier transform unit 577. As a result, complex signals Va(x,y) and Vb(x,y) are obtained which correspond to the signals received by antennas 534a and 534b at each observation point on the observation plane 533.

Additionally, fixed antenna 578 is provided, the output of which is a reference signal which becomes a reference phase for the signals received by antennas 534a and 534b, this reference signal too is converted to a complex signal. That is, the output of fixed antenna 578 is converted to an IF signal in a frequency converter 579 using the local signal from local oscillator 576, a discrete Fourier transform is performed on this converted IF signal by discrete Fourier transform unit 581 and reference complex signal $V_R$ is obtained as a result.

The complex signals Va(x,y) and Vb(x,y) for each observation point (x,y) are divided in interferometer 582 by reference complex signal $V_R$ to produce two-dimensional interference data Ha(x,y) and Hb(x,y) respectively. These interference data divided in interferometer 582 by reference complex signal $V_R$ to produce two-dimensional interference data Ha(x,y) and Hb(x,y) are switchably selected by switch 583 and are memorized in interference data memories 584, 585. In this example, information indicative of the observation point (x,y), designated by control unit 586, is used as the address signal for the memories 584, 585. Moreover, control unit 586 controls the switches 574 and 583.

Hologram reconstruction calculations of the observation plane 533 are performed on interference data Ha(x, y) and Hb(x,y) by hologram reconstruction calculation units 587, 588 according to the following equations:

$$Ia(u,v) = \int \int Ha(x,y) \exp\{-j2\pi(ux+vy)\} \ dx \ dy$$

$$Ib(u,v) = \int \int Hb(x,y) \exp\{-j2\pi \ (ux+vy)\} \ dx \ dy \qquad (5)$$

Ia(u,v) and Ib(u,v) resulting from these hologram reconstruction calculations are memorized in holographic memories 589, 591 respectively. In this case, it is assumed that the detected electromagnetic waves are elliptically polarized, that the axial ratio, etc., of polarisation of the polarized wave vector Iab(u,v,φ) can be measured and that the hologram reconstruction results Ia(u,v) and Ib(u,v) are the vertical and horizontal components of the elliptically polarized wave vector. A polarization calculation unit 592 determines the wave vector for each observation point (u,v) according to the following equation:

$$Iab(u,v) = Ia(u,v) \cos\varphi + Ib(u,v) \sin\varphi \qquad (6).$$

That is, the polarized wave vector Iab is equal to the horizontal component Ib(u,v) when $\varphi = \pi/2$ and is equal to the vertical component Ia(u,v) when $\varphi = 0$.

For each observation point (u,v) values $\varphi_{MA}$ and $\varphi_{MI}$ are calculated at which the absolute value of the polarized wave vector Iab becomes a maximum and a minimum, respectively. $|Iab(u,v,\varphi_{MA})|$ is a major axis of the elliptically polarized electromagnetic wave at the observation point (u,v) and $|Iab(u,v,\varphi_{MI})|$ is the minor axis of the elliptically polarized wave. Therefore, the axial ratio AR(u,v) of the elliptically polarized wave is given by the following equation:

$$AR(u,v) = \left|Iab(u,v,\varphi_{MA})\right| / \left|Iab(u,v,\varphi_{MI})\right| \qquad (7)$$

When the axial ratio AR(u,v) is equal to 1 this indicates a circularly polarized electromagnetic wave. When the axial ratio AR(u,v) is equal to infinity then this indicates a linearly polarized electromagnetic wave.

In addition, the inclination $\theta(u,v)$ in the direction in which the elliptically polarized wave progresses is obtained as a difference between the phase of vertical component Ia(u,v) and the phase of the horizontal component Ib(u,v).

The value $\varphi_{MA}$ at which the absolute value of the polarized wave vector Iab becomes a maximum is given by the following equation:

$$\varphi_{MA} = (1/2)\tan^{-1} \{2 \, |Ia(u,v)| \, |Ib(u,v)| \, \cos(\theta(u,v)) \, /(|Ia(u,v)|^2 + |Ib(u,v)|^2)\} \qquad (8)$$

Because this information is a phase it is input to hue converter 514. Because the axial ratio AR(u,v) is not phase information, an angle of elliptical aperture $\tau(u,v)$, which corresponds to phase, is calculated according to the following equation:

$$\tau(u,v) = (1/2)\sin^{-1} \{2 \, |Ia(u,v)| \, |Ib(u,v)| \, \sin(\theta(u,v)) \, / \, (|Ia(u,v)|^2 + |Ib(u,v)|^2)\} \qquad (9)$$

Any of the parameters inclination $\theta(u,v)$, axial ratio AR(u,v) or rotating angle $\varphi_{MA}$ (major axis angle) can be selected and supplied to hue converter 514 of Fig.1, and strength (major axis) $|Ia(u,v,\varphi_{MA})|$ may be supplied to multiplication unit 515. In this case, co-ordinate conversion is performed beforehand from the orthogonal co-ordinates to polar co-ordinates.

According to the invention, complex two-dimensional wave interference data can be displayed in a manner giving a feeling of distance in a direction at a right angle to the observation plane by converting the phase information into a hue signal and modulating the hue signal by amplitude information. That is, complex three-dimensional space can be displayed using two-dimensional computer graphics.

**Claims**

1. A complex wave interference information display apparatus comprising:

   interference data observing means (511) for observing complex two-dimensional wave interference data;
   means (512) for performing hologram reconstruction calculations of said interference data;
   means (513) for converting coordinates of results of said hologram reconstruction calculations from orthogonal to polar coordinates;
   means (514) for converting phase information of coordinates-converted data to hue information;
   means (515) for modulating data of hue information by amplitude information of coordinate-converted data; and
   display means (516) for displaying said modulated data as two-dimensional color images.

2. A complex wave interference information display apparatus according to claim 1 wherein said interference data observing means (511) receives waves on an observation plane of a holographic radar and converts received signals to complex signals.

3. A complex wave interference information display apparatus according to claim 2 wherein said interference data observing means (511), in use, receives two-dimensional interference waves in a three-dimensional space at a number of observation points on an observation plane (535) and converts received signals to complex signals.

4. A complex wave interference information display apparatus according to claim 3, where receiving electromagnetic waves at said observation points is performed by an antenna-element pair (534a,534b) with mutually orthogonal 8-figured beam patterns, and where holograms are acquired from complex two-dimensional interference data received from said antenna-element pair, and where polarized wave vectors are acquired where said holograms are vertical and horizontal components, and where either of axial ratio, rotating angle or inclination at the direction of propagation of the polarized wave vectors is used as phase information.

**Patentansprüche**

1. Vorrichtung zur Anzeige von Informationen über die Interferenz komplexer Wellen, die aufweist:

   - eine Interferenzdatenbeobachtungseinrichtung (511) zur Beobachtung der Interferenzdaten komplexer zweidimensionaler Wellen;
   - eine Einrichtung (512) zur Durchführung von Hologramm-Rekonstruktionsberechnungen der Interferenzdaten;
   - eine Einrichtung (513) zur Umwandlung der Koordinaten der Ergebnisse der Hologramm-Rekonstruktionsberechnungen von orthogonalen Koordinaten zu Polarkoordinaten;
   - eine Einrichtung (514) zur Umwandlung der Phaseninformation von koordinativ umgewandelten Daten in eine Farbtoninformation;
   - eine Einrichtung (515) zur Modulation der Daten von Farbtoninformationen durch Amplitudeninformation von koordinativ umgewandelten Daten; und
   - eine Anzeigeeinrichtung (516) zur Anzeige der modulierten Daten in Form von zweidimensionalen Farbbildern.

2. Vorrichtung zur Anzeige von Informationen über die Interferenz komplexer Wellen nach Anspruch 1, bei der die Interferenzdatenbeobachtungseinrichtung (511) Wellen auf einer Beobachtungsebene eines holographischen Radarsystems empfängt und die empfangenen Signale in komplexe Signale umwandelt.

3. Vorrichtung zur Anzeige von Informationen über die Interferenz komplexer Wellen nach Anspruch 2, bei der die Interferenzdatenbeobachtungseinrichtung (511) im Betrieb zweidimensionale Interferenzwellen in einem dreidimensionalen Raum an einer Anzahl von Beobachtungspunkten auf einer Beobachtungsebene (535) empfängt und die empfangenen Signale in komplexe Signale umwandelt.

4. Vorrichtung zur Anzeige von Informationen über die Interferenz komplexer Wellen nach Anspruch 3, bei der der Empfang von elektromagnetischen Wellen an den Beobachtungspunkten von einem Paar von Antennenelementen (534a, 534b) mit zueinander orthogonalen Peilachtstrahl-Empfangsmustern durchgeführt wird, und wobei Hologramme von komplexen zweidimensionalen Interferenzdaten erhalten werden, die von dem Paar von Antennenelementen empfangen werden, und wobei polarisierte Wellenvektoren erhalten werden, wobei die Hologramme senkrechte und waagrechte Komponenten sind, und wobei entweder das axiale Verhältnis, der Drehwinkel oder die Neigung zur Ausbreitungsrichtung der polarisierten Wellenvektoren als Phaseninformation verwendet werden.

**Revendications**

1. Dispositif d'affichage d'informations complexes d'interférences d'ondes comprenant :

   un moyen d'observation de données d'interférences (511) destiné à observer des données complexes d'interférences d'ondes à deux dimensions,
   un moyen (512) destiné à exécuter des calculs de reconstitution d'hologramme desdites données d'interférences,
   un moyen (513) destiné à convertir des coordonnées des résultats desdits calculs de reconstitution d'hologramme à partir de coordonnées orthogonales vers des coordonnées polaires,
   un moyen (514) destiné à convertir des informations de phase des données à coordonnées converties en des informations de teinte,
   un moyen (515) destiné à moduler des données des informations de teinte par des informations d'amplitude des données à coordonnées converties, et

un moyen d'affichage (516) destiné à afficher lesdites données modulées sous forme d'images en couleur à deux dimensions.

**2.** Dispositif d'affichage d'informations complexes d'interférences d'ondes selon la revendication 1, dans lequel ledit moyen d'observation de données d'interférences (511) reçoit des ondes sur un plan d'observation d'un radar holographique et convertit les signaux reçus en des signaux complexes.

**3.** Dispositif d'affichage d'informations complexes d'interférences d'ondes selon la revendication 2, dans lequel ledit moyen d'observation de données d'interférences (511), en utilisation, reçoit des ondes d'interférences à deux dimensions dans un espace à trois dimensions pour un certain nombre de points d'observation sur un plan d'observation (535) et convertit les signaux reçus en des signaux complexes.

**4.** Dispositif d'affichage d'informations complexes d'interférences d'ondes selon la revendication 3, où la réception des ondes électromagnétiques au niveau desdits points d'observation est exécutée grâce à une paire d'éléments d'antenne (534a, 534b) présentant des profils de faisceaux mutuellement orthogonaux en forme de chiffre 8, et où des hologrammes sont acquis à partir de données complexes d'interférences à deux dimensions reçues depuis ladite paire d'éléments d'antenne, et où des vecteurs d'ondes polarisées sont acquis, où lesdits hologrammes sont des composantes verticale et horizontale, et où l'un ou l'autre d'un rapport axial, d'un angle de rotation ou d'une inclinaison à la direction de propagation des vecteurs d'ondes polarisées est utilisé en tant qu'informations de phase.

*FIG.1*

## FIG.2

## FIG.3

# FIG.4

*FIG.5*